Europäisches Patentamt

European Patent Office

Office européen des brevets

(11) Publication number: **0 293 981**
**A2**

## EUROPEAN PATENT APPLICATION

(21) Application number: **88201071.3**

(22) Date of filing: **30.05.88**

(51) Int. Cl.4: **H01L 39/24**

(30) Priority: **04.06.87 GB 8713121**
**04.06.87 GB 8713122**

(43) Date of publication of application:
**07.12.88 Bulletin 88/49**

(84) Designated Contracting States:
**DE FR GB IT**

(71) Applicant: **IMI TITANIUM LIMITED**
**P.O. Box 704**
**Witton Birmingham B6 7UR(GB)**

(72) Inventor: **Barber, Antony Clifford**
**135 Darnick Road**
**Sutton Coldfield West Midlands, B73**
**6PG(GB)**
Inventor: **Farmer, Francis John Vernon**
**82 Avery Road Parkland**
**Sutton Coldfield West Midlands, B73**
**6QF(GB)**
Inventor: **Hayfield, Peter Charles Steele**
**Church Garth St. Peters Lane Bickenhill**
**Lane**
**Solihull West Midlands, B29 0DR(GB)**
Inventor: **Scholes, Ian Robert**
**40 Walsall Road**
**Sutton Coldfield West Midlands, B74**
**4QR(GB)**

(74) Representative: **Sykes, John Christopher et al**
**IMI plc Patents & Licensing Department**
**Kynoch Works P.O. Box 216**
**Witton Birmingham B6 7BA(GB)**

(54) **Processes for the manufacture of superconducting inorganic compounds and the products of such processes.**

(57) Processes for manufacturing high $T_c$ superconductors by electrophoretic deposition onto a substrate or by coating onto the substrate a plurality of components in solution or suspension and subsequent heat treatment. The substrate is preferably conducting and may be silver and the coating or deposition may be further coated with a layer of metal or resin.

## Processes for the Manufacture of Superconducting Inorganic Compounds and the Products of Such Processes

This invention relates to processes for the manufacture of superconducting inorganic compounds and the products of such processes.

It is now well established that certain ceramic compositions will become superconducting when held at sufficiently low temperature. More recently a rare earth containing material, $YBa_2Cu_3O_{7-x}$, has been shown to become superconducting at liquid nitrogen temperature as opposed to much lower temperatures essential for inducing superconductivity in metals, alloys and intermetallics previously used. Such novel ceramic composition material has become known as high $T_c$ ceramic. This patent application relates especially, but not exclusively, to the formation of 'thick' film devices and to wire/tape formation. The technique is applicable to the formation of ceramic compositions other than $YBa_2Cu_3O_{7-x}$, for example the BiSrCaCuO formulation.

According to one aspect of the invention we provide a process for manufacturing a superconducting inorganic compound on a substrate including the steps of roughening a surface of the substrate, depositing on said surface particles of a superconducting inorganic compound from a suspension of such particles by electrophoresis.

The superconducting inorganic compound may subsequently be covered with a resin or varnish or a metal layer such as copper or silver may be deposited thereon. For example, pure copper may be deposited and then coated by a resin or varnish. Alternatively, pure copper may be deposited on the superconducting inorganic compound, and the product together with its substrate may then be inserted into a copper or copper alloy cannister, which is subsequently extruded into filaments. A substance which acts as a barrier to substantially prevent further diffusion from the metal layer during subsequent processing may be placed upon the superconducting inorganic compound prior to deposition of the metal layer.

The superconducting inorganic compound is typically an oxide of the form $A_wB_xO_y$ where A and B represent elements of which at least one is a metallic element and the subscripts w x and y are numerals denoting the empirical atomic proportions of the compound conducting oxide. There may be additional metallic elements eg. $C_z$ etc present in the compound conducting oxide.

Such compound conducting oxides may be of the form $ABO_3$, $ABO_4$ or $A_2BO_4$ or $A_2BO_{(4-y)}$. Typical elements involved in the formation of these superconducting oxides are yttrium, barium, bismuth, lanthanum, strontium and copper. The present invention is not limited to these elements: the yttrium may be replaced by other rare earth elements, the barium by other alkali elements, and the entire compound may not be a cuprate, but a bismuthate or other compound. The deposited layer will be in a combined rather than elemental state, and typically would be an oxide.

The metallic layer, which could be copper or a copper alloy, may be deposited immediately following the removal of unattached suspension or contaminants eg. by washing or other cleaning process, from the oxide coated substrate. The substrate is typically an electrically conducting material such as a metal eg. silver, copper or a copper alloy, or molybdenum or titanium or an alloy of one of these. It may be coated by a barrier film prior to the deposition stage.

Alternatively, a metallic layer may be deposited after an intermediate treatment such as a heat-treatment of the coated substrate.

According to another aspect of the invention we provide a process for manufacturing a superconducting inorganic compound on a substrate including the steps of roughening a surface of the substrate, depositing on said surface particles of a plurality of different compounds such as oxides or carbonates or a mixture of oxides and carbonates from a suspension of such particles by electrophoresis. Such compounds may include organo-metallic substances.

The deposit may subsequently be covered with a resin or varnish or a metal layer may be deposited thereon. For example, pure copper may be deposited and then coated by a resin or varnish. Alternatively, pure copper may be deposited on the existing deposit, and the resulting product together with its substrate inserted into a copper or copper alloy cannister, which is subsequently extruded into filaments. A substance which acts as a barrier to substantially prevent further diffusion from the metallayer during subsequent processing may be placed upon the existing deposit prior to deposition of the metal layer. Preferably prior to the deposit of any layer of resin or metal, the oxide/carbonate coated substrate may be heat-treated in an oxidising atmosphere at elevated temperatures sufficient to cause said particles to chemically react together to form a superconducting inorganic compound. The oxides and/or carbonates will typically include at least one metallic compound. The oxide/carbonate coated substrate could be cleaned in a manner referred to above prior to the heat treatment.

The substrate may be metallic eg. silver, gold, titanium, copper or molybdenum or it may be an electrically conducting ceramic or a carbon-containing substance. The substrate may be silver-coated or platinum-coated. The substrate may be fully dense or it may be porous. The substrate may be copper cored. In either aspect of the invention the substrate may be in the form of a strip, tape or wire, tube, plate or disc. The surface of the substrate may be plane, curved, corrugated or stepped. For example the substrate may be a wire with multiple re-entrant portions eg. star-shaped when viewed in cross-section. Alternatively the substrate may be a substantially plane disc with micro-grooves on its surface.

After the depositing of the metallic layer the oxide-coated substrate may be mechanically worked eg. by drawing, extruding or rolling, so as to consolidate the superconducting compound. Such mechanical working may take place at ambient temperature or at an elevated temperature. The material may also be subject to heat treatment. Further mechanical working and heat treatment may also be necessary.

A bundle of strips, tapes or wires so formed may then be bundled together in an evacuated metallic cannister eg. of copper or copper alloy or silver-coated copper or alloy, and such container and its contents co-extruded or drawn in multiple stages to produce a fine elongate product containing a plurality of filaments of conducting oxide material. An oxygen-evolving compound or substance eg. silver oxide may be incorporated with the bundle of strips etc on their admission to the cannister.

An electromagnetic field eg a magnetic field, may be applied during the electrophoretic deposition stage to encourage the deposited particles to take up a particular orientation.

In all aspects of the invention fibrous particles such as ceramic fibres, alumina or zirconia fibres or silicon carbide fibres may be incorporated into the suspension and electrophoretically deposited onto the surface of the substrate. The particles being deposited may be substantially rounded, or may be acicular or platelet-type in shape. Sizes of particles deposited are typically up to a few microns in size, but larger sizes can be accommodated by attention to the viscosity of the electrophoreting bath.

The roughening of the surface of the substrate may be carried out by etching eg. with copper by ammonium persulphate and/or ferric sulphate, or in the case of molybdenum by pickling in hydrochloric acid.

The suspension may be dispersed in an electrolyte which includes nitromethane and isopropyl alcohol and possibly additionally zein and aluminium nitrate as necessary for efficient electrophoresis.

According to a still further aspect of the invention we provide a process for manufacturing a superconducting inorganic compound on a substrate including the steps of roughening a surface of the substrate, applying a fluid coating onto said surface, the coating comprising a plurality of components in suspension and/or in solution in a liquid medium. Said components may comprise metallic compounds such as a chloride, sulphate or nitrate or a citrate, acetate and other salts. The coated substrate is typically heated to a temperature sufficient to cause decomposition of said components and the formation of a surface film of superconducting inorganic compound incorporating each of the elements present.

A plurality of successive coatings may be applied, each of said successive coatings containing identical components, or at least some of each of said successive coatings containing differing components. Where a solution is applied to the substrate, it may comprise metal compounds dissolved in an organic base, such as so-called "organo-metallic paints".

According to another aspect of the invention we provide a process for manufacturing a superconducting inorganic compound on a substrate including the steps of roughening a surface of the substrate, applying a coating on the said surface, the coating comprising a suspension of particles of a superconducting inorganic compound suspended in a liquid medium. Successive coatings may be built up one upon the other. The coated substrate may then be given a heat treatment in e.g. an oxygen-containing atmosphere such as pure oxygen at atmospheric, sub-atmospheric or elevated pressure. The average particle size of the superconducting inorganic compound may be less than one micron.

A drying step may be incorporated into the processes according to the invention following the application of the or each coating. Such drying step may be carried out in air and is completed when the liquid medium is substantially evaporated. Relatively volatile dispersion medium is typically selected for example an alcohol.

Where heating is used, this may take place in an oxygen containing atmosphere. Heating is typically carried out between a temperature of 400-500°C. The coating may be applied to a cool substrate which is then heated to change the deposit to the desired composition. Alternatively the coating can wholly or in part be applied eg. by spraying, onto a heated substrate so as to effect decompositioned changes at a fast and homogeneous rate.

Where multiple coatings may be applied to the substrate, each such coating may in turn be dried to remove the liquid medium before the application of the next coating. The superconducting inorganic compound may subsequently be covered with a resin or varnish or a metal layer may be deposited thereon. For example, pure copper may be deposited, or silver deposited by thermal decomposition technique, and the copper or silver then coated by a resin or varnish. Alternatively, pure copper may be deposited on the superconducting inorganic compound, and together with its substrate inserted into a copper or copper alloy cannister, which is subsequently extruded into filaments. A substance which acts as a barrier to substantially prevent further diffusion from the metal layer during subsequent processing, eg. niobium or silver, may be placed upon the superconducting inorganic compound prior to deposition of the metal layer.

The substrate may be metallic eg. silver, gold, titanium, copper or molybdenum or an alloy or it may be a ceramic. The substrate may be fully dense or it may be porous. The substrate may be copper cored. The substrate may be silver or silver-coated.

According to a still further aspect of the invention we provide a process for manufacturing a superconducting inorganic compound on a substrate, where such substrate is a metal such as copper or a copper alloy, said process including the steps of roughening the surface of the substrate eg. by immersion in ammonium persulphate, coating the roughened surface of the substrate with a suspension of a plurality of particles of different metals, such as yttrium or barium, and subsequently heating the coated substrate in an atmosphere and at a temperature which results in the oxidisation of the metal substrate and the metal particles so as to form a superconducting inorganic compound. In this latest aspect of the invention, the surface of the substrate may be preheated in an oxygen-containing atmosphere prior to coating, such that where the metal substrate is eg. copper, a layer of copper oxide (CuO) is formed on the surface of the copper. Such heating may take place in air for example at a temperature of 200-300°C. Alternatively, a copper oxide (CuO) layer may be formed on a copper substrate by electrolytic means prior to the coating step.

In all aspects of the invention, fibres eg. of alumina or zirconia or silicon carbide may be incorporated in one or more of the coatings. Similarly, carbon-containing compounds such as oxalates or citrates may be incorporated in the coatings. Flake copper or silver powder may also or alternatively be incorporated in one or more coatings.

The products of the processes according to the invention have properties which make them useable as superconducting materials. As a wire or tape it may be incorporated in or onto the surface of a carrier such as a disk for storing data in electronic form. Alternatively, the coated substrate may after subsequent processing be useful as a contact capable of carrying high current flows or for passing pulsed currents.

One embodiment of the invention will now be described, by way of example only.

A platelet shaped $YBa_2Cu_3O_7$ ceramic powder made by the citrate route was milled to give a particle size of between 1 and 6 microns.

A suspension was prepared of the powder in isopropyl alcohol and nitromethane. Zein was added as an activator and a small amount of aluminium nitrate was also added.

The quantities of the suspension were as follows

$YBa_2Cu_3O_7$ ceramic 10 gms
Zein 0.2 gm
Nitromethane 50 mls
Isopropyl alcohol 50 mls
Aluminium nitrate 0.005 gm

The substrate was a roughened silver wire positioned between two platinised titanium anodes, the potential of the wire being negative (cathodic) relative to the anodes, the assembly being immersed in the suspension. Up to 50 volts constant voltage was applied between the anodes and the cathode, with a cell current typically of about 10 mA being measured.

Between applied voltages of 0-50 volts there was a straight-line relationship between the quantity of electrophoretic deposition in $gm/cm^2$ and voltage. The quantity of deposition at constant voltage was also initially a straight-line increasing relationship but this eventually fell off after about 4 minutes.

For a deposition at 30 volts over 2 minutes, the coated substrate was removed from the assembly, washed in isopropyl alcohol and dried in air at 120°C. The coated substrate was then baked in air at 550°C to remove organic matter and subsequently sintered at 930°C in oxygen/air and finally annealed in oxygen at 450°C.

## Claims

1. A process for manufacturing a superconducting inorganic compound on a substrate including the steps of roughening a surface of the substrate, depositing on said surface particles of a superconducting inorganic compound from a suspension of such particles by electrophoresis.

2. A process for manufacturing a superconducting inorganic compound on a substrate including the steps of roughening a surface of the substrate, depositing on said surface particles of a plurality of different compounds such as oxides or carbonates or a mixture of oxides and carbonates from a suspension of such particles by electrophoresis.

3. A process for manufacturing a superconducting inorganic compound on a substrate including the steps of roughening a surface of the substrate, applying a coating onto said surface, the coating comprising a plurality of components in suspension and/or in solution in a liquid medium.

4. A process for manufacturing a superconducting inorganic compound on a substrate including the steps of roughening a surface of the substrate, applying a coating on the said surface, the coating comprising a suspension of particles of a superconducting inorganic compound suspended in a liquid medium.

5. A process according to any preceding claim in which the superconducting inorganic compound is subsequently covered with a resin or varnish or a layer of metal.

6. A process according to Claim 5 in which a substance which acts as a barrier to substantially prevent further diffusion from the metal layer during subsequent processing is placed upon the superconducting inorganic compound prior to deposition of the metal layer.

7. A process as claimed in any preceding claim in which the substrate is silver or silver coated or platinum coated.

8. A process as claimed in any of Claims 1 to 6 in which the substrate is an electrically conducting ceramic.

9. A process as claimed in Claim 5 in which after deposition of the metallic layer, the substrate coated with the inorganic compound is mechanically worked.

10. A process as claimed in Claim 4 in which the coated substrate is subsequently provided with a heat treatment in an oxygen-containing atmosphere.

11. A process in which the particles being electrophoretically deposited are rounded in shape, acicular or platelet type.

12. A process in which the electrophoresis is carried out under the influence of a strong magnetic field.